# EUROPÄISCHE PATENTSCHRIFT

(11) **EP 0 664 591 B1**
(45) Veröffentlichungstag und Bekanntmachung des Hinweises auf die Patenterteilung: **05.04.2000**
(21) Anmeldenummer: 95100505.7
(22) Anmeldetag: 16.01.1995
(51) Int. Cl.: H01S 5/068, H01S 5/06, H04B 10/145

(54) **Laserdiodensender mit Burstregelung**
Diode lasertransmitter with burst control
Transmetteur laser à diode avec contrôle de rafale

(30) Priorität: 24.01.1994 DE 4401884
(43) Veröffentlichungstag der Anmeldung: 26.07.1995
(73) Patentinhaber: SIEMENS AKTIENGESELLSCHAFT, 80333 München (DE)
(72) Erfinder: Lehmann,Uwe,Dipl.-Ing., D-85221 Dachau (DE); Schweinberger,Johannes,Dipl.-Ing., D-82327 Tutzing (DE)

(56) Entgegenhaltungen:
- EP-A- 0 314 390
- EP-A- 0 347 202
- US-A- 4 985 896
- PATENT ABSTRACTS OF JAPAN vol. 008 no. 235 (E-275) ,27.Oktober 1984 & JP-A-59 117336 (FUJITSU KK) 6.Juli 1984,

## Beschreibung

Die Erfindung betrifft ein Verfahren zur Burstregelung eines Laserdiodensenders und einen Laserdiodensender zur Durchführung des Verfahrens.

Die in Laserdiodensendern verwendeten Halbleiterlaserdioden besitzen Kennlinien für die Umwandlung des elektrischen Stroms in das auszusendende Licht, deren nutzbarer Bereich oberhalb eines bestimmten Schwellenstroms liegt. Dieser Schwellenstrom ist einerseits exemplarabhängig und ändert sich andererseits stark mit der Temperatur und während der Lebensdauer. Zusätzlich ist die Steilheit des als Arbeitskennlinie verwendeten Teils der Wandlerkennlinie ebenfalls stark von der Temperatur abhängig und erheblichen Exemplarstreuungen unterworfen. Üblicherweise wird deshalb den Laserdioden neben einem geregelten Vorstrom auch ein geregelter Modulationsstrom zugeführt, wobei zur Regelung häufig ein Regelsignal verwendet wird, das durch eine optisch mit der Laserdiode gekoppelte Monitor-Photodiode erzeugt wird. Beispielsweise aus der DE A1 2847182 bekannte Laserregelschaltungen arbeiten dabei im Prinzip mit zwei voneinander abhängigen Regelschleifen, deren Regelinformationen, die mittlere Lichtleistung und den Spitzenwert des Modulationssignals betreffend, durch Gleichspannungssignale dargestellt werden. Die Regelkriterien sind dabei Ausgangssignale von Tiefpaßfiltern, die in entsprechend langsamen Regelschlelfen weiterverarbeitet werden. Damit ist ein eingeschwungener Betrieb des Laserdiodensenders Voraussetzung für die Funktion der Regelung.

In modernen teilnehmernahen Übertragungssystemen wird in zunehmendem Maße, beispielsweise für die Übertragung von der teilnehmernahen Endstelle zur Zentrale im Burstbetrieb gearbeitet, bei dem Impuls- beziehungsweise Datenpakete mittels optischer Burstsignale übertragen werden. Insbesondere wegen der langen Einschwingzeiten ist die Übertragung von Burstsignalen mit diesen bekannten Laserdiodensendern nicht möglich, da die Signalübertragung jeweils in die Anlaufphase der Regelung fallen würde.

Die Aufgabe bei der vorliegenden Erfindung besteht also darin, das eingangs erwähnte Verfahren zur Laserdiodenregelung und den entsprechenden Laserdiodensender so weiterzubilden, daß die Übertragung vergleichsweise kurzer Burstsignale, beispielsweise mit einer Dauer von 1-10µs bei Burstabständen von 1µs bis zu 5s auch schon wahrend der Netzeinmeßphase unmittelbar nach der Ersteinschaltung mit geringen Impulsverzerrungen möglich ist.

Erfindungsgemäß wird die Aufgabe durch ein Verfahren gelöst, das entsprechend den Patentansprüchen 1 und 2 ausgebildet ist und durch einen Laserdiodensender entsprechend den Patentansprüchen 3 und den folgenden Patentansprüchen.

Die Erfindung soll im folgenden anhand eines in der Zeichnung dargestellten Ausführungsbeispieles naher erläutert werden. Dabei zeigt:
- Figur 1: ein Blockschaltbild für eine Spitzenlichtregelung in einem erfindungsgemäßen Laserdiodensender für Burstsignale,
- Figur 2: ein Zeit- bzw. Impulsdiagramm für den Laserdiodensender nach Figur 1 und
- Figur 3: das Detailschaltbild einer im erfindungsgemäßen Laserdiodensender eingesetzten Modulationsstromregelung.-

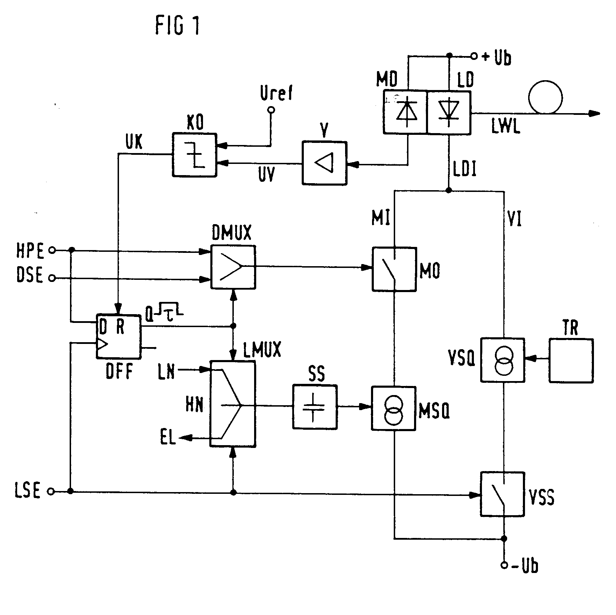

Der in Figur 1 dargestellte Laserdiodensender enthält ein D-Flip-Flop DFF, dessen D-Eingang mit einem Eingang HPE für ein Signal entsprechend dem logischen Hochpegel und dessen auslösender Eingang mit einem Eingang LSE für ein Signal zur Laser-Sender-Freigabe verbunden ist. Das Signal zur Laser-Sender-Freigabe wird von einer externen Steuerung sehr kurze Zeit vor der geplanten Aussendung der optischen Burstsignale erzeugt. Mit dem Eingang LSE ist weiterhin ein Eingang für eine Einschaltsignal eines Lademultiplexers LMUX sowie der Steuereingang eines gesteuerten Schalters VSS verbunden, der zwischen einem Anschluß -Ub für eine negative Betriebsspannung und dem entsprechenden Betriebsspannungsanschluß einer Vorstromquelle VSQ geschaltet ist. Mit dem nichtinvertierenden Ausgang Q des D-Flip-Flops sind ein Steuereingang des Lademultiplexers LMUX sowie ein Steuereingang eines Signalmultiplexers DMUX verbunden. Ein Eingangsanschluß des Signalmultiplexers DMUX ist mit dem Eingang HPE für ein Hochpegelsignal verbunden, ein weiterer Eingangsanschluß des Signalmultiplexers DMUX ist mit dem Datensignaleingang DSE verbunden, an dem das zu übertragende Datenpaket von der externen Steuerung veranlaßt, eine Zeit τ nach der Erzeugung des Signals zur Lasersender-Freigabe ansteht. Der Signalmultiplexer LMUX stellt einen gesteuerten Umschalter mit drei Schaltstellungen dar, wobei in der oberen Schalterstellung der Ausgang des Lademultiplexers mit dem Eingangsanschluß LN verbunden ist, an dem eine extern erzeugte Ladespannung ansteht. In der mittleren Schalterstellung des Lademultiplexers LMUX ist dieser freilaufend, so daß in dieser Schalterstellung weder Spannungen zu- noch abgeführt werden. In der unteren Schalterstellung EL ist der Lademultiplexer LMUX mit Bezugspotential verbunden, so daß in dieser Schalterstellung ein Entladevorgang des am Ausgang des Lademultiplexers angeschlossenen Spannungsspeichers SS möglich ist. Der Spannungsspeicher SS, beispielsweise in Form eines Kondensators ,ist zusätzlich mit einem Steuereingang einer Modulationsstromquelle MSQ verbunden, wobei der von dieser Stromquelle erzeugte Strom sich linear mit der Spannung am Spannungsspeicher SS ändert. Die Modulationsstromquelle MSQ ist außerdem mit der negativen Betriebsspannungsquelle -Ub und über einen Modulator MO in Form eines gesteuerten Schalters mit der Laserdiode LD des Laserdiodensenders verbunden. Die Steuerung des Modulators MO erfolgt vom Ausgang des Signalmultiplexers DMUX, der mit einem entsprechendem Steuersignaleingang des Modulators verbunden ist. Die mit der Laserdiode zusätzlich verbundene Vorstromquelle VSQ erzeugt einen Vorstrom für die Laserdiode, der durch die Temperaturregelung TR in Abhängigkeit von der Temperatur an einer Außenfläche der Laserdiode geregelt wird. Das von der Laserdiode LD erzeugte Licht wird einerseits zur Signalübertragung in einen Lichtwellenleiter LWL eingekoppelt, an der anderen Seite der Laserdiode ist zusätzlich eine Monitor-Photodiode an die Laserdiode angekoppelt und erzeugt in Abhängigkeit von der jeweiligen Lichtleistung der Laserdiode einen Photostrom, der einem Photostromverstärker V zugeführt wird. Die Laserdiode und die Monitorphotodiode sind in üblicher Weise mit einer Quelle für eine positive Betriebsspannung +Ub verbunden. Vom Photostromverstärker V wird ein der mittleren Lichtleistung der Laserdiode entsprechendes Spannungssignal an einen Signaleingang eines schnellen Spannungskomparators KO abgegeben, dessen Vergleichssignaleingang mit einer Quelle für eine Referenzspannung Uref verbunden ist. Sobald die Eingangssignale des Komparators KO gleichgroß sind, ändert sich der Pegel an dessen Ausgang und damit an dem unmittelbar angeschlossenem Rücksetzeingang R des D-Flip-Flops und auch an dessen nichtinvertierendem Ausgang Q.

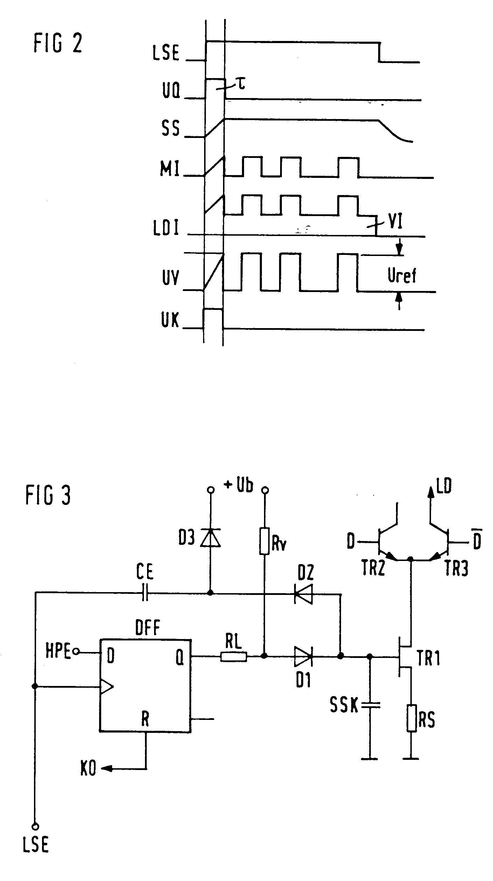

Zur Erläuterung der Wirkungsweise der Figur 1 wird das in Figur 2 dargestellte Zeit- bzw. Impulsdiagramm herangezogen.

Die mit LSE bezeichnete obere Zeile zeigt den Verlauf des am entsprechenden Eingang anstehenden Lasersender-Freigabesignals, durch das der Lasersender aktiviert wird und das über den Takteingang des D-Flip-Flops dieses umschaltet. Damit springt der Pegel am nichtinvertierenden Ausgang Q des D-Flip-Flops, wie in der zweiten, mit UQ bezeichneten Zeile dargestellt, auf Hochpegel.

In der Einschaltphase ist der Lademultiplexer LMUX so geschaltet, daß über den mit LN bezeichneten Eingang ein Ladestrom zum Lademultiplexerausgang und damit zum Spannungsspeicher SS fließt. In der dritten, mit SS bezeichneten Zeile ist der Spannungsverlauf am Spannugnsspeicher SS und damit auch am Steuersignaleingang der Modulationsstromquelle MSQ dargestellt. Der Ladestromkreis für den Spannungsstromkreis SS ist dabei so ausgebildet, daß sich die Spannung am Spannungsspeicher und damit auch der in der Zeile MI dargestellte Modulationsstrom zeitlinear unabhängig vom Dateninhalt erhöhen. Unter der Zeile für den Modulationsstrom ist der mit LDI bezeichnete gesamte durch die Laserdiode fließende Strom dargestellt. Es ist erkennbar, daß sich dieser Laserdiodenstrom aus dem Modulationsstrom und einem Gleichstromanteil zusammensetzt, der den Vorstrom VI zur Einstellung des Arbeitspunktes der Laserdiode darstellt.

Entsprechend der abgegebenen Lichtleistung erzeugt die Monitorphotodiode MD einen Photostrom, der vom Photostromverstärker V in eine Spannung UV umgewandelt wird, die in der entsprechend bezeichneten Zeile dargestellt ist und vom Komparator KO mit der extern erzeugten Referenzspannung Uref verglichen wird. Solange die Spannung UV dabei kleiner als die Re£erenzspannung ist, steht am Komparatorausgang ein Hochpegel an, der bei Gleichheit beider Komparatorspannungen wieder abgeschaltet wird, der Verlauf dieses Pegels UK ist in der untersten Zeile der Figur 2 dargestellt.

In der Figur 3 sind die die Modulationsstromregelung betreffenden Schaltungsteile des Blockschaltbildes nach Figur 1 unter Verzicht auf die Monitorphotodiode, den Photostromverstärker und den Komparator detailliert dargestellt. Mit dem Eingangsanschluß LSE für das Laser-Sender-Freigabesignal ist wiederum der Takteingang des D-Flip-Flops DFF und mit dessen D-Eingang der Anschluß HPE für ein Hochpegelsignal verbunden, ebenfalls ist der Rücksetzeingang R an den Ausgang des nicht dargestellten Komparators KO angeschlossen. Der Lademultiplexer DMUX ist durch die erste und die zweite Diode D1, D2, den Ladewiderstand RL und den Entladekondensator CE realisiert. Dazu ist mit dem nichtinvertierenden Ausgang Q des D-Flip-Flops über einer Reihenschaltung aus dem Ladewiderstand RL und der ersten Diode D1 der Spannungsspeicher SS in Form eines Kondensators SSK und der Gate-Anschluß eines ersten Transistors TR1 verbunden. Der Source-Anschluß dieses Transistors TR1 ist über einen Source-Widerstand RS an Bezugspotential angeschlossen, während der Drain-Anschluß des ersten Transistors TR1 mit den Emitteranschlüssen eines zweiten und eines dritten Transistors TR2, TR3 verbunden ist. Der zweite und der dritte Transistor TR2, TR3 bilden einen emittergekoppelten Differenzverstärker, der mit den zu übertragenden Daten D im Gegentakt angesteuert wird und bei dem wahlweise mit dem Kollektoranschluß des zweiten oder des dritten Transistors TR2, TR3 die Laserdiode verbunden ist. An der Verbindungsstelle zwischen dem Ladewiderstand RL und der ersten Diode D1 ist ein Vorwiderstand RV angeschlossen, der an den Anschluß für die positive Betriebsspannung +UB geführt ist und der zusammen mit dem Ladewiderstand RL einen Spannungsteiler ergibt, durch den die positive Betriebsspannung auf die Größe der Schwellenspannung des Feldeffekttransistors TR1 verringert wird, dadurch ist sichergestellt, daß der erste Transistor TR1 immer im aktiven Bereich bleibt. Wahrend der Ladephase des Spannungsspeicherkondensators SSK ist die erste Diode D1 durchgängig, mit Erreichen der Haltephase wird diese Diode gesperrt. In dieser Phase ist auch die zusätzlich mit dem Spannungsspeicher verbundene Serienschaltung aus zweiter Diode D2 und Entladekondensator CE gesperrt, da der Entladekondensator CE mit dem Eingangsanschluß LSE für das Laser-Sender-Freigabesignal verbunden ist und dieses während der Haltephase - wie aus der Zeile 1 von Figur 2 hervorgeht - auf Hochpegel liegt. Mit dem Ende des Lasersender-Freigabesignals steht am Eingangsanschluß LSE der niedrige oder L-Pegel an, so daß sich über die Reihenschaltung aus zweiter Diode D2 und Entladekondensator CE der Spannungsspeicherkondensator SSK auf eine Spannung entladen kann, die nur vom Kapazitätsverhältnis des Spannungsspeicherkondensator und des Entladekondensators und der Spannung bei Entladungsbeginn abhängt. Hiermit wird erreicht, daß der Entladevorgang in weiten Grenzen von den sich jeweils anschließenden Burst-Pausen unabhängig ist. Zusätzlich ist an der Verbindung zwischen zweiter Diode D2 und Entladekondensator CE eine dritte Diode D3 angeschlossen, deren anderer Anschluß an den Anschluß für die positive Betriebsspannung +UB gefuhrt ist. Die dritte Diode D3 ist so gepolt, daß beim nächsten Burst-Signal der Entladekondensator CE über diese Diode mit dem Hochpegel des Laser-Sender-Freigabesignal wieder entladen wird. Durch die gezielte Entladung sowohl des Spannungsspeicherkondensators SSK als auch des Entladekondensators CE wird erreicht, daß eine Überladung des Spannungsspeichers und damit ein zu hoher Modulationsstrom ausgeschlossen ist, die Ladepulsdauer τ, also die Zeit bis zum Erreichen des maximalen Modulationsstroms, ist außerdem so eingestellt, daß sie immer größer als die Verzögerung im Regelkreis ist.

## Patentansprüche

1. Verfahren zur getrennten Regelung des Vorstroms und des Modulationsstroms eines Laserdiodensenders, bei dem mittels einer mit der sendenden Laserdiode optisch gekoppelten Monitorphotodiode aus der Lichtleistung der Laserdiode Regelsignale abgeleitet werden,
**dadurch gekennzeichnet**,
daß zur Übertragung von auch als Burstsignalen bezeichneten Impulspaketen vergleichsweise kurze Zeit vor Burstbeginn der Vorstrom der Laserdiode sprungartig eingeschaltet wird und damit begonnen wird, einen Spannungswert und den von dem Spannungswert abhängigen Modulationsstrom der Laserdiode zeit-linear unabhängig vom Dateninhalt soweit zu erhöhen, bis eine voreingestellte maximale Lichtleistung erreicht wird, daß anschließend für die Burstdauer dieser Spannungswert und damit der maximal mögliche Modulationsstromwert gespeichert wird,
daß am Burstende, also bei einem Wechsel des logischen Pegels des Lasersender-Freigabesignals am auslösenden Eingang (LSE) des Laserdiodensenders und beim Auftreten eines niedrigpegligen Datensignals am Datensignaleingang (DSE) des Laserdiodensenders der Laserdiodenvorstrom abgeschaltet wird und der den Modulationsstrom steuernde Spannungswert definiert entladen wird.

2. Verfahren nach Anspruch 1,
**dadurch gekennzeichnet,**
daß der Vorstrom der Laserdiode in Abhängigkeit von der Temperatur an einer Laserdiodenoberfläche nachgeregelt wird.

3. Laserdiodensender zur Durchführung des Verfahrens nach Anspruch 1
**dadurch gekennzeichnet**,
daß mit einem Eingangsanschluß (LSE) für ein Lasersender-Freigabesignal der Takteingang eines D-Flip-Flops (DFF) und der Anschluß für das Eingangssignal eines Lademultiplexers (LMUX) verbunden ist, daß mit dem nichtinvertierendem Ausgang (Q) des D-Flip-Flop (DFF) die Steuersignal- bzw. Umschalteingänge des Lademultiplexers (LMUX) und eines Signalmultiplexers (DMUX) verbunden sind, daß mit einem Eingangs anschluß für ein Hochpegelsignal (HPE) der D-Eingang des D-Flip-Flops und ein entsprechender Eingang des Datenmultiplexers (DMUX) verbunden sind, daß mit einem weiteren Eingang des Signalmultiplexers (DMUX) der Eingangsanschluß (DSE) für das zu übertragende Datensignal verbunden ist, daß der Ausgangsanschluß des Lademultiplexers (LMUX) mit einem Spannungsspeicher (SS) verbunden ist, an dem der Steuersignaleingang einer Modulationsstromquelle (MSQ) angeschlossen ist, daß die Modulationsstromquelle (MSQ) außerdem einerseits mit einem Anschluß für eine negative Betriebsspannung (-UB) und andererseits mit einem ersten Stromanschluß eines Modulators (MO) verbunden ist, an dessen zweiten Stromanschluß die sendende Laserdiode (LD) angeschlossen ist, daß mit dem Ausgangsanschluß des Datenmultiplexers (DMUX) ein Steuersignaleingang des Modulators (MO) verbunden ist, daß mit dem Anschluß (+UB) für die positive Betriebsspannung die Laserdiode und ein erster Anschluß einer mit der Laserdiode optisch gekoppelten Monitor-Photodiode verbunden ist, an deren anderem Anschluß ein Photostromverstärker (V) angeschlossen ist, der eine dem Photostrom der Monitor-Photodiode entsprechende verstärkte Spannung erzeugt, die an einen Eingang des mit dem Ausgang des Photostromverstärkers (V) verbundenen schnellen Komparators KO abgegeben wird, daß ein anderer Eingangsanschluß des Komparators (KO) mit einem Anschluß für eine Referenzspannung (Uref) verbunden ist und daß der Ausgang des Komparators (KO) mit dem Rücksetzeingang R des D-Flip-Flops (DFF) verbunden ist, daß zusätzlich mit dem Eingangsanschluß (LSE) für das Lasersender-Freigabesignal der Steuersignaleingang eines gesteuerten Schalters (VSS) verbunden ist, der in den Stromweg zwischen dem Anschluß (-UB) für die negative Betriebsspannung und dem einen Stromanschluß einer Vorstromquelle (VSQ) eingeschaltet ist, daß der andere Stromanschluß der Vorstromquelle (VSQ) mit demjenigen Anschluß der Laserdiode (LD) verbunden ist, an den auch die Modulationsstromquelle (MO) angeschlossen ist.

4. Laserdiodensender nach Anspruch 3,
**dadurch gekennzeichnet**,
daß ein Temperaturregler (TR) vorgesehen ist, dessen Eingangsanschluß mit einem mit der Laserdiode (LD) thermisch gekoppelten Heißleiter und dessen Ausgangsanschluß mit einem Steuersignaleingang der Vorstromquelle (VSQ) verbunden ist.

5. Laserdiodensender nach Patentanspruch 3,
**dadurch gekennzeichnet**,
daß mit dem nichtinvertierenden Ausgang Q des D-Flip-Flops über eine Reihenschaltung aus einem Ladewiderstand (RL) und einer ersten Diode (D1) der Gate-Anschluß eines ersten Transistors (TR1) in Form eines Feldeffekttransistors und der eine Anschluß eines Spannungsspeicherkondensator (SSK) verbunden ist, dessen anderer Anschluß mit Bezugspotential verbunden ist, daß der Source-Anschluß des ersten Transistors (TR1) über einen Sourcewiderstand (RS) mit Bezugspotential verbunden ist, daß der Drain-Anschluß des ersten Transistors (TR1) mit dem zusammengeführten Emitteranschlüssen eines zweiten und eines dritten Transistors (TR2, TR3) verbunden ist, daß wahlweise der Basisanschluß des zweiten oder des dritten Transistors (TR2, TR3) direkt oder beide Basisanschlüsse über eine Gegentaktansteuerung mit dem Eingangsanschluß (DSE) für die zu übertragenden Daten verbunden sind, daß die Laserdiode (LD) wahlweise mit dem Kollektoranschluß des zweiten oder des dritten Transistors (TR2, TR3) verbunden ist, daß der Gate-Anschluß des ersten Transistors (Tr1) über eine Reihenschaltung aus einer zweiten Diode (D2) und einem Entladekondensator (CE) mit dem Eingangsanschluß (LSE) für das Lasersender-Freigabesignal verbunden ist, daß der Verbindungspunkt zwischen dem Ladewiderstand (RL) und der ersten Diode (D1) über einen Vorwiderstand R(V) mit dem Anschluß für die positive Betriebsspannung (+UB) verbunden ist und dabei der Vorwiderstand (RV) so dimensioniert ist, daß sich durch die Spannungsteilung mit dem Ladewiderstand (RL) die Schwellenspannung des Feldeffekttransistors (TR1) ergibt und daß am Verbindungspunkt der zweiten Diode (D2) und dem Entladekondensator (CE) eine dritte Diode (D3) angeschlossen ist, deren anderer Anschluß mit der Quelle für die positive Betriebsspannung (+UB) verbunden ist.

## Claims

1. Method for separately controlling the biasing current and the modulation current of a laser diode transmitter, in which control signals are derived from the light output of the laser diode by means of a monitor photodiode optically coupled to the transmitting laser diode, characterized in that for the purpose of transmitting pulse packets, also denoted as burst signals, a comparatively short time before the start of a burst the biasing current of the laser diode is switched on abruptly and thereby a start is made in increasing a voltage value and the modulation current of the laser diode, dependent on the voltage value, doing so, in a fashion which is independent of the data contents in the temporary linear fashion, until a preset maximum light output is reached, in that subsequently this voltage value, and thus the maximum possible modulation current value, is stored for the burst period, and in that at the end of the burst, that is to say upon a change in the logic level of the laser transmitter enabling signal at the tripping input (LSE) of the laser diode transmitter and upon the occurrence of a low-level data signal at the data signal input (DSE) of the laser diode transmitter, the laser diode biasing current is switched off and the voltage value controlling the modulation current is discharged in a defined fashion.

2. Method according to Claim 1, characterized in that the biasing current of the laser diode is corrected as a function of the temperature at a laser diode surface.

3. Laser diode transmitter for carrying out the method according to Claim 1, characterized in that the clock input of a D flip-flop (DFF) and the terminal for the input signal of a loading multiplexer (LMUX) are connected to an input terminal (LSE) for a laser transmitter enabling signal, in that the control signal inputs and/or change of signal inputs of the loading multiplexer (LMUX) and of a signal multiplexer (DMUX) are connected to the non-inverting output (Q) of the D flip-flop (DFF), in that the D input of the D flip-flop and a corresponding input of the data multiplexer (DMUX) are connected to an input terminal for a high-level signal (HPE), in that the input terminal (DSE) for the data signal to be transmitted is connected to a further input of the signal multiplexer (DMUX), in that the output terminal of the loading multiplexer (LMUX) is connected to a voltage accumulator (SS) to which the control signal input of a modulation current source (MSQ) is connected, in that, furthermore, the modulation current source (MSQ) is connected, on the one hand, to a terminal for a negative operating voltage (-UB) and, on the other hand, to a first current terminal of a modulator (MO) to whose second current terminal the transmitting laser diode (LD) is connected, in that a control signal input of the modulator (MO) is connected to the output terminal of the data multiplexer (DMUX), in that connected to the terminal (+UB) for the positive operating voltage are the laser diode and a first terminal of a monitor photodiode which is optically coupled to the laser diode and to whose other terminal there is connected a photocurrent amplifier (V) which generates an amplified voltage which corresponds to the photocurrent of the monitor photodiode and is supplied to an input of the fast comparator (KO) connected to the output of the photocurrent amplifier (V), in that another input terminal of the comparator (KO) is connected to a terminal for a reference voltage (Uref) and the output of the comparator (KO) is connected to the reset input R of the D flip-flop (DFF), in that there is additionally connected to the input terminal (LSE) for the laser transmitter enabling signal the control signal input of a controlled switch (VSS) which is inserted into the current path between the terminal (-UB) for the negative operating voltage and one current terminal of a biasing current source (VSQ), and in that the other current terminal of the biasing current source (VSQ) is connected to that terminal of the laser diode (LD) to which the modulation current source (MO) is also connected.

4. Laser diode transmitter according to Claim 3, characterized in that a temperature controller (TR) is provided whose input terminal is connected to a thermistor thermally coupled to the laser diode (LD), and whose output terminal is connected to a control signal input of the biasing current source (VSQ).

5. Laser diode transmitter according to Claim 3, characterized in that connected to the non-inverting output Q of the D flip-flop via a series circuit of a charging resistor (RL) and a first diode (D1) are the gate terminal of a first transistor (TR1) in the form of a field effect transistor and one terminal of a voltage accumulator capacitor (SSK) whose other terminal is connected to reference potential, in that the source terminal of the first transistor (TR1) is connected to reference potential via a source resistor (RS), in that the drain terminal of the first transistor (TR1) is connected to the joined emitter terminals of a second and a third transistor (TR2, TR3), in that the base terminal of the second or the third transistor (TR2, TR3) is optionally connected directly to, or both base terminals are connected via a push-pull drive circuit, to the input terminal (DSE) for the data to be transmitted, in that the laser diode (LD) is optionally connected to the collector terminal of the second or the third transistor (TR2, TR3), in that the gate terminal of the first transistor (TR1) is connected via a series circuit of a second diode (D2) and a discharging capacitor (CE) to the input terminal (LSE) for the laser transmitter enabling signal, in that the tie point between the charging resistor (RL) and the first diode (D1) is connected via a series resistor (RV) to the terminal for the positive operating voltage (+UB), and in this case the series resistor (RV) is dimensioned such that the threshold voltage of the field effect transistor (TR1) results from the voltage division with the charging resistor (RL), and in that connected to the tie point of the second diode (D2) and the discharging capacitor (CE) is a third diode (D3) whose other terminal is connected to the source for the positive operating voltage (+UB).

## Revendications

1. Procédé pour la régulation séparée du courant préalable et du courant de modulation d'un émetteur à diode laser, dans lequel on déduit des signaux de régulation à partir de la puissance lumineuse de la diode laser au moyen d'une photodiode de moniteur couplée de façon optique à la diode laser émettrice,
caractérisé par le fait que
pour la transmission de paquets d'impulsions aussi appelés signaux de salves, on branche brusquement le courant préalable de la diode laser relativement peu de temps avant le début de salve et on commence à augmenter une valeur de tension et le courant de modulation, dépendant de la valeur de tension, de la diode laser de façon linéaire par rapport au temps et indépendamment du contenu de données jusqu'à atteindre une puissance lumineuse maximale prescrite,
ensuite, on mémorise pour la durée de salve cette valeur de tension et donc la valeur de courant de modulation maximale possible,
à la fin de salve, c'est-à-dire lors d'un changement du niveau logique du signal de libération d'émetteur laser à l'entrée de déclenchement (LSE) de l'émetteur à diode laser et lors de l'apparition d'un signal de données de niveau bas à l'entrée de signal de données (DSE) de l'émetteur à diode laser, on débranche le courant préalable de diode laser et on décharge de manière définie la valeur de tension commandant le courant de modulation.

2. Procédé selon la revendication 1, caractérisé par le fait qu'on régule après coup le courant préalable de la diode laser en fonction de la température sur une surface de diode laser.

3. Emetteur à diode laser pour la mise en oeuvre du procédé selon la revendication 1,
caractérisé par le fait que
l'entrée d'horloge d'une bascule bistable de type D (DFF) et la borne destinée au signal d'entrée d'un multiplexeur de charge (LMUX) sont reliées à une borne d'entrée (LSE) destinée à un signal de libération d'émetteur laser, que les entrées de signal de commande et de commutation du multiplexeur de charge (LMUX) et d'un multiplexeur de signal (DMUX) sont reliées à la sortie non inversée (Q) de la bascule bistable de type D (DFF), que l'entrée D de la bascule bistable de type D et une entrée correspondante du multiplexeur de signal (DMUX) sont reliées à une borne d'entrée pour un signal de niveau haut (HPE), que la borne d'entrée (DSE) destinée au signal de données à transmettre est reliée à une autre entrée du multiplexeur de signal (DMUX), que la borne de sortie du multiplexeur de charge (LMUX) est reliée à un accumulateur de tension (SS) auquel est raccordée l'entrée de signal de commande d'une source de courant de modulation (MSQ), que la source de courant de modulation (MSQ) est reliée en outre d'une part à une borne destinée à une tension de service négative (- UB) et d'autre part à une première borne de courant d'un modulateur (MO) dont la deuxième borne de courant est raccordée à la diode laser émettrice (LD), qu'une entrée de signal de commande du modulateur (MO) est reliée à la borne de sortie du multiplexeur de signal (DMUX), que la borne (+ UB) destinée à la tension de service positive est reliée à la diode laser et à une première borne d'une photodiode de moniteur qui est couplée de façon optique à la diode laser et dont l'autre borne est raccordée à un amplificateur de courant photo-électrique (V) produisant une tension amplifiée qui correspond au courant photo-électrique de la photodiode de moniteur et qui est délivrée à une entrée du comparateur (KO) rapide relié à la sortie de l'amplificateur de courant photo-électrique (V), qu'une autre borne d'entrée du comparateur (KO) est reliée à une borne destinée à une tension de référence (Uref) et que la sortie du comparateur (KO) est reliée à l'entrée de remise à l'état initial R de la bascule bistable de type D (DFF), que, en plus, la borne d'entrée (LSE) pour le signal de libération d'émetteur laser est reliée à l'entrée de signal de commande d'un interrupteur commandé (VSS) qui est branché dans le trajet de courant entre la borne (- UB) destinée à la tension de service négative et une borne de courant d'une source de courant préalable (VSQ), que l'autre borne de courant de la source de courant préalable (VSQ) est reliée à celle des bornes de la diode laser (LD) à laquelle est aussi raccordée la source de courant de modulation (MO).

4. Emetteur à diode laser selon la revendication 3,
caractérisé par le fait qu'il est prévu un régulateur de température (TR) dont la borne d'entrée est reliée a un thermistor couplé de façon thermique à la diode laser (LD) et dont la borne de sortie est reliée à une entrée de signal de commande de la source de courant préalable (VSQ).

5. Emetteur à diode laser selon la revendication 3,
caractérisé par le fait que
la sortie non inversée Q de la bascule bistable de type D est reliée par l'intermédiaire d'un circuit série composé d'une résistance de charge (RL) et d'une première diode (D1) à la borne de grille d'un premier transistor (TR1) sous la forme d'un transistor à effet de champ et à une borne d'un condensateur accumulateur de tension (SSK) dont l'autre borne est reliée au potentiel de référence, que la borne de source du premier transistor (TR1) est reliée par l'intermédiaire d'une résistance de source (RS) au potentiel de référence, que la borne de drain du premier transistor (TR1) est reliée aux bornes d'émetteurs réunies d'un deuxième et d'un troisième transistor (TR2, TR3), que, au choix, la borne de base du deuxième ou du troisième transistor (TR2, TR3) est reliée directement à la borne d'entrée (DSE) destinée aux données à transmettre ou bien les deux bornes de bases sont reliées par l'intermédiaire d'une commande symétrique à cette borne d'entrée (DES), que la diode laser (LD) est reliée au choix à la borne de collecteur du deuxième ou du troisième transistor (TR2, TR3), que la borne de grille du premier transistor (TR1) est reliée par l'intermédiaire d'un circuit série composé d'une deuxième diode (D2) et d'un condensateur de décharge (CE) à la borne d'entrée (LSE) destinée au signal de libération d'émetteur laser, que le point de jonction entre la résistance de charge (RL) et la première diode (D1) est relié par l'intermédiaire d'une résistance série (RV) à la borne destinée à la tension de service positive (+ UB), la résistance (RV) étant dimensionnée de telle sorte que le seuil de tension du transistor à effet de champ (TR1) résulte de la division de tension avec la résistance de charge (RL), et que le point de jonction entre la deuxième diode (D2) et le condensateur de décharge (CE) est raccordé à une troisième diode (D3) dont l'autre borne est reliée à la source destinée à la tension de service positive (+ UB).
